Europäisches Patentamt

European Patent Office

Office européen des brevets

(11) **EP 0 973 186 A2**

(19)

(12) ## EUROPEAN PATENT APPLICATION

(43) Date of publication:
**19.01.2000 Bulletin 2000/03**

(51) Int Cl.7: **H01J 37/12**, H01J 37/317

(21) Application number: **99305532.6**

(22) Date of filing: **13.07.1999**

(84) Designated Contracting States:
**AT BE CH CY DE DK ES FI FR GB GR IE IT LI LU
MC NL PT SE**
Designated Extension States:
**AL LT LV MK RO SI**

(30) Priority: **15.07.1998 EP 98202365**

(71) Applicant: **ASM LITHOGRAPHY B.V.
5503 LA Veldhoven (NL)**

(72) Inventor: **Bleeker, Arno Jan
5615 LK Eindhoven (NL)**

(74) Representative: **Leeming, John Gerard
J.A. Kemp & Co.,
14 South Square,
Gray's Inn
London WC1R 5LX (GB)**

(54) **Lithographic apparatus**

(57)   A lithographic apparatus comprising:

- a radiation system (7) for supplying a projection beam of charged particles;
- a mask table (5) for holding a mask (29);
- a substrate table (1) for holding a substrate (19);
- a projection system (3) for imaging an irradiated portion of the mask (29) onto a target portion (35) of the substrate (19),

the projection system (3) comprising at least three quadrupole lenses arranged successively along the path (25) of the beam.

Fig.5.

EP 0 973 186 A2

**Description**

The invention relates to a lithographic apparatus comprising:

- a radiation system for supplying a projection beam of charged particles;
- a mask table for holding a mask;
- a substrate table for holding a substrate;
- a projection system for imaging an irradiated portion of the mask onto a target portion of the substrate.

An apparatus of this type can be used, for example, in the manufacture of integrated circuits (ICs). In such a case, the mask (reticle) may contain a circuit pattern corresponding to an individual layer of the IC, and this pattern can then be imaged onto a target area (die) on a substrate (silicon wafer) which has been coated with a layer of photosensitive material (resist). In general, a single wafer will contain a whole network of adjacent dies that are successively irradiated through the reticle, one at a time. In one type of lithographic projection apparatus, each die is irradiated by exposing the entire reticle pattern onto the die in one go; such an apparatus is commonly referred to as a waferstepper. In an alternative apparatus - which is commonly referred to as a step-and-scan apparatus - each die is irradiated by progressively scanning the reticle pattern under the projection beam in a given reference direction (the "scanning" direction) while synchronously scanning the wafer table parallel or anti-parallel to this direction; since, in general, the projection system will have a magnification factor M (generally < 1), the speed v at which the wafer table is scanned will be a factor M times that at which the reticle table is scanned. More information with regard to lithographic devices as here described can be gleaned from International Patent Application WO 97/33205.

Up to very recently, apparatus of this type contained a single mask table and a single substrate table. However, machines are now becoming available in which there are at least two independently movable substrate tables; see, for example, the multi-stage apparatus described in International Patent Applications WO 98/28665 and WO 98/40791. The basic operating principle behind such multi-stage apparatus is that, while a first substrate table is underneath the projection system so as to allow exposure of a first substrate located on that table, a second substrate table can run to a loading position, discharge an exposed substrate, pick up a new substrate, perform some initial alignment measurements on the new substrate, and then stand by to transfer this new substrate to the exposure position underneath the projection system as soon as exposure of the first substrate is completed, whence the cycle repeats itself; in this manner, it is possible to achieve a substantially increased machine throughput, which in turn improves the cost of ownership of the machine.

Lithographic apparatus may employ various types of projection radiation, such as ultra-violet light (UV), extreme UV, X-rays, ion beams or electron beams, for example. Depending on the type of radiation used and the particular design requirements of the apparatus, the projection system may be refractive, reflective or catadioptric, for example, and may comprise vitreous components, grazing-incidence mirrors, selective multi-layer coatings, magnetic and/or electrostatic field lenses, *etc;* for simplicity, such components may be loosely referred to in this text, either singly or collectively, as a "lens". The apparatus may comprise components that are operated in vacuum, and are correspondingly vacuum-compatible. As mentioned in the previous paragraph, the apparatus may have more than one substrate table and/or mask table.

The radiation systems in currently available lithographic devices deliver ultra-violet (UV) light, which can be derived from an excimer laser or mercury lamp, for example, such radiation typically having a wavelength of 365 nm or 248 nm. However, the rapidly developing electronics industry continually demands lithographic devices which can achieve ever-higher resolutions, and this is forcing the industry toward even shorter-wavelength radiation, particularly UV light with a wavelength of 193 nm or 157 nm. Beyond this point, there are several possible scenarios, including the use of extreme UV light, X-rays, ion beams or electron beams. The current invention relates to the latter two categories, which are described, for example, in United States Patents US 5,436,460 and US 5,079,112, respectively.

The optical systems used in currently proposed charged-particle lithographic projection systems are conventionally based on rotationally symmetric lenses. Typically, two lenses are used in telecentric mode: the first lens has a focal length F, the second lens has a focal length MF (where M is the magnification of the system), and the distance between the lenses is (M + 1)F, so that the focal points coincide. The object (mask) is situated in the front focal plane of the first lens, whereas the image (substrate) is located in the back focal plane of the second lens.

Through the use of a telecentric system, geometric and chromatic aberrations are reduced, but still significant. These aberrations, together with stochastic blur, determine the ultimate resolution of the system. *Via* the stochastic blur, this resolution is dependent on the current through the projection system column.

It is an object of the invention to alleviate these problems. In particular, it is an object of the invention to provide a charged-particle lithographic apparatus having reduced aberrations. Moreover, it is an object of the invention that such a system should have improved resolution compared to state-of-the-art devices.

These and other objects are achieved in an apparatus as stated in the opening paragraph, characterized in that the projection system comprises at least three quadrupole lenses arranged successively along the path of the projection beam. This invention exploits the following insights.

The phenomenon of stochastic blur is caused by the mutual forces between charged particles in a projection beam, which forces can cause a deviation of the particles from their intended path. The main contribution to such stochastic blur occurs in the region in which the particle beam is most narrow *i.e.* the crossover. Known systems as described above all have a circular crossover disk situated at the focal point in between the lenses. The crossover size is determined by the opening angle of the illumination optics, the field-size, and the aberrations of the system. There are limited possibilities to minimize the stochastic effect by changing these parameters: the best choice of parameters is a tradeoff between stochastic and aberration blur. On average, the blur should be equally divided between both contributions.

Contrary to a system of rotationally symmetric lenses, a system consisting of one or more quadrupoles will, in general, have non-circular (astigmatic) crossovers. The average distance between the charged particles in these crossovers will be much larger than in a rotationally symmetric system, resulting in less mutual interaction between the particles, and thus less stochastic blur. A contrafactor is that the system will have at least two crossovers, which will tend to increase the stochastic blur. However the total stochastic blur in a system with two non-circular crossovers will typically be less than the stochastic blur in a rotationally symmetric system.

In particular embodiments of the invention, the projection system comprises 3, 4 or 5 quadrupole lenses.

One embodiment of the invention employing three quadrupole lenses is characterized in that:

- the magnification factor M of the projection system;
- the respective focal lengths $f_1$, $f_2$, $f_3$ ofthe quadrupole lenses;
- the mutual separations $b_{M1}$, $b_{12}$, $b_{23}$, $b_{3S}$ of the mask table and the first quadrupole lens, the first and second quadrupole lens, the second and third quadrupole lens, and the third quadrupole lens and substrate table, respectively,

are such that the following relationships are at least approximately satisfied:

$$f_3 = +Mf_1;$$

$$f_2 = -Mf_1;$$

$$b_{23} = Mb_{12};$$

$$b_{3S} = Mb_{M1}.$$

Such an embodiment gives stigmatic focusing. The minus sign indicates that the focusing action of the second lens is reversed - if the focal length of a quadrupole is +f in the x-plane, then the focal length in the y plane will be -f: the minus sign in the case of the second lens indicates that the focal length in the x plane is -f, whereas that in the y plane is +f.

With regard to the nomenclature introduced in the previous paragraph and employed hereinafter in the Description and Claims, it should be noted that the ordinals 1,2,3,... refer to the lenses when considered successively in a direction extending from the mask table [M] towards the substrate table [S]. In addition, the phrase "at least approximately" should be interpreted as requiring that each of the stipulated relationships be satisfied to within about ± 15 %, and preferably to within about ± 5-10 %, with exact satisfaction being an ideal situation.

An embodiment of the inventive apparatus employing four quadrupole lenses is characterized in that:

- the magnification factor M of the projection system;
- the respective focal lengths $f_1$, $f_2$, $f_3$, $f_4$ of the quadrupole lenses;
- the mutual separations $b_{M1}$, $b_{12}$, $b_{23}$, $b_{34}$, $b_{4S}$ of the mask table and the first quadrupole lens, the first and second quadrupole lens, the second and third quadrupole lens, the third and fourth quadrupole lens, and the fourth quadrupole lens and substrate table, respectively;
- the respective excitations $E_1$, $E_2$, $E_3$, $E_4$ of the quadrupole lenses,

are such that the following relationships are at least approximately satisfied:

$$f_3 = Mf_1;$$

$$f_4 = Mf_2;$$

$$b_{34} = Mb_{12};$$

$$b_{4S} = Mb_{M1};$$

$$b_{23} = b_{4S} + b_{M1};$$

$$E_1 = E_3;$$

$$E_2 = E_4.$$

Such a set-up is telescopic, *i.e.* a parallel-incoming ray will result in a parallel-outgoing ray, in both the x and y plane. The "excitation" of a quadrupole lens is a term that is standard in the art of charged-particle optics, and refers to:

- in the case of a magnetic lens employing a deflecting coil, the product of the electrical current through the coil and the number of turns in the coil;
- in the case of an electrostatic lens, the electrical potential across the lens.

In a refinement of the embodiment described in the previous paragraph, the geometrical dimensions of the third and fourth quadrupole lenses are scaled by a factor M with respect to the geometrical dimensions of the first and second quadrupole lenses. For example, if M = 1/4, then the third and fourth quadrupole lenses are a factor 4 smaller than the first and second quadrupole lenses. A system built this way closely resembles commonly-proposed telecentric systems with rotationally symmetric lenses, but has greatly reduced aberrations and distortions.

A practical shortcoming of a four-quadrupole system is that the distance $b_{34}$ between the third and fourth quadrupoles may be rather small, leading to a somewhat cluttered system requiring the use of rather compact quadrupoles. However, a system with an additional quadrupole can overcome this problem: compare, for example, Embodiments 3 and 2 below.

In addition to the quadrupole lenses already referred to, the projection system according to the invention may also contain other elements. For example:

- it may contain one or more rotationally symmetric lenses (as in Embodiment 4 below, for example);
- the addition of one or more sextupoles, octupoles, *etc.,* at strategic points can further help to reduce aberrations. If desired, the quadrupoles and such correcting n-poles (n > 4 and even) can be combined into one element, so that the total number of elements does not become excessive;
- deflectors can be included so as to achieve alignment, scanning action and "stitching", if needed (see, for example, European Patent Application EP 98201997.8 (P-0113));
- one or more aperture stops / diaphragms can be included in the beam path. For example, a slit-like aperture can be located at each astigmatic crossover in the projection system; this serves to capture scattered particles in SCALPEL-like systems as described in US 5,079,112. Moreover, off-axis slits can be used to achieve the phenomenon of "ghosting" as described, for example, in US 5,701,014 and US 5,561,009.

The actual shape and size of the various lenses can be chosen such that mutual aberrations tend to cancel.

It should be explicitly noted that all lenses referred to in this text may be electrostatic, magnetostatic or a combination of both.

The invention also relates to a device manufacturing method comprising the steps of:

- providing a substrate which is at least partially covered by a layer of radiation-sensitive material;
- providing a mask which contains a pattern;

- using a projection beam of charged-particle radiation to project an image of at least

part of the mask pattern onto a target area of the layer of radiation-sensitive material. According to the invention, such a method is characterized in that, prior to impinging on the substrate, the projection beam is passed through at least three quadrupole lenses, arranged successively along its path.

In a manufacturing process using a lithographic projection apparatus according to the invention, a pattern in a mask is imaged onto a substrate which is at least partially covered by a layer of energy-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, *e.g.* an IC. Such a patterned layer may then undergo various processes such as etching, ion-implantation (doping), metallization, oxidation, chemo-mechanical polishing, *etc.,* all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, *etc.* Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference has been made hereabove to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, *etc.* The skilled artisan will appreciate that, in the context of such alternative applications, any use of the terms "reticle", "wafer" or "die" in this text should be considered as being replaced by the more general terms "mask", "substrate" and "target area", respectively.

The invention and its attendant advantages will be further elucidated with the aid of exemplary Embodiments and the accompanying schematic drawings, wherein:

Figure 1 shows the traces of the principal rays through a projection system consisting of three quadrupole lenses;
Figure 2 shows the traces of the principal rays through a projection system consisting of four quadrupole lenses;
Figure 3 shows the traces of the principal rays through a projection system consisting of five quadrupole lenses;
Figure 4 shows the traces of the principal rays through a projection system consisting of two rotationally symmetric lenses and four quadrupole lenses;
Figure 5 renders a perspective view of a lithographic projection apparatus according to the invention;
Figure 6 gives a perspective view of a quadrupole lens that can be employed in the invention.

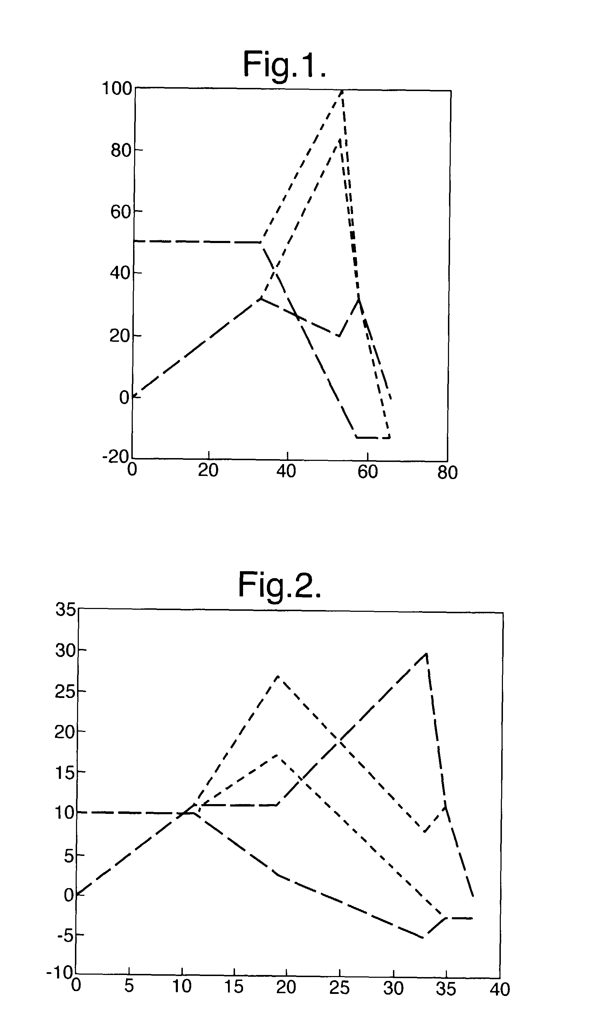

Corresponding features in the various Figures are denoted by the same reference symbols. Figures 1-4 represent a plot of radial position as a function of axial position (both in mm); in each case, the heavy broken lines correspond to principal rays in the x plane, whereas the fine broken lines correspond to principal rays in the y plane. Ray-trace figures of this type are standard in the art of charged-particle optics, and are used, for example, in *Principles of Electron Optics* by P. Hawkes and E. Kasper, Academic Press, London, 1989.

Embodiment 1

In a particular embodiment of the apparatus according to the invention, the projection system consists of three quadrupole lenses. Figure 1 shows the traces of the principal rays through such a three-quadrupole system, which satisfies the following conditions:

$$M = 1/4;$$

$$f_1 : f_2 : f_3 = +20 : -6.472 : +5;$$

$$b_{M1} : b_{12} : b_{23} : b_{3S} = 32.361 : 20 : 5 : 8.09,$$

It is seen that the system is not telescopic: in the y plane, a parallel-incoming principal ray does not result in a parallel-outgoing ray. This means that this system can be quite sensitive to stage displacements (*i.e.* displacements of the mask or substrate tables) in the axial direction.

Embodiment 2

In another embodiment of the apparatus according to the invention, the projection system consists of four quadrupole lenses. Figure 2 shows the traces of the principal rays through such a four-quadrupole system, which satisfies the following conditions:

$$M = 1/4;$$

$$f_1 : f_2 : f_3 : f_4 = +11.024 : -7.983 : +2.756 : -1.996;$$

$$b_{M1} : b_{12} : b_{23} : b_{34} : b_{4S} = 11: 8 : 13.75 : 2 : 2.75.$$

It is evident that a parallel-incoming ray results in a parallel-outgoing ray, in both the x and y plane. This means that the system is telescopic, so that a small change in the axial position of a stage does not directly lead to a large change in magnification.

Embodiment 3

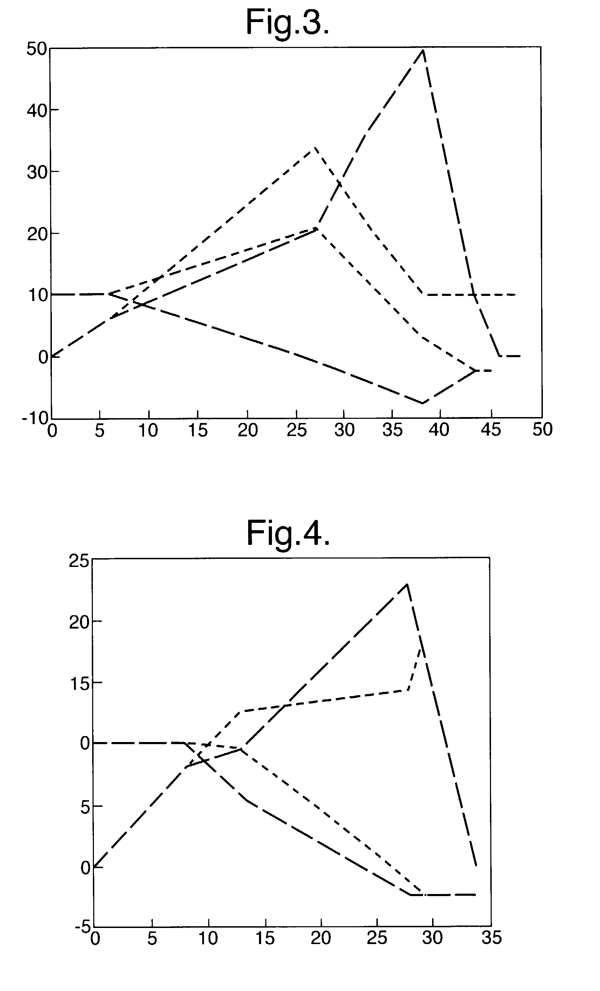

Figure 3 relates to a projection system based on five quadrupole lenses and satisfying the following conditions:

$$M = 1/4;$$

$$f_1 : f_2 : f_3 : f_4 : f_5 = +19.165 : -9.331 : +70 : +4.813 : -2.475;$$

$$b_{M1} : b_{12} : b_{23} : b_{34} : b_{45} : b_{5S} = 6 : 21 : 5.253 : 6 : 5 : 2.5,$$

in which $f_5$ is the focal length of the fifth quadrupole lens, $b_{45}$ is the mutual separation of the fourth and fifth quadrupole lenses, and $b_{5S}$ is the mutual separation of the fifth quadrupole lens and the substrate table. An advantage of the use of the fifth quadrupole lens is the increase in distance $b_{45}$ between the last two quadrupole lenses (as compared to $b_{34}$ in Embodiment 2). Once again, this system is telescopic.

Embodiment 4

Figure 4 relates to a possible set-up with a combination of two rotationally symmetric lenses and four quadrupole lenses. The configuration of the two rotationally symmetric lenses is the same as in a telecentric system, but these two lenses are supplemented by two quadrupole lenses (astigmators), each placed so as to coincide with one of the rotationally symmetric lenses. Two additional quadrupole lenses are placed in between the two rotationally symmetric lenses, such that a telecentric condition is re-established in the x and y planes. This system satisfies the following conditions:

$$f_1 : f_2 : f_3 : f_4 : f_5 : f_6 = +20 : +25.621 : -15.612 : +4.804 : -5.204 : +5;$$

$$b_{M1} : b_{12} : b_{23} : b_{34} : b_{45} : b_{56} : b_{6S} = 8 : 0: 5 : 15 : 1.25 : 0: 4.5,$$

in which the subscripts 1-6 refer, successively, to the first rotationally symmetric lens [1], the four quadrupole lenses [2-5] and the second rotationally symmetric lens [6].
In this embodiment, the strength of the quadrupole lenses is rather large as compared to the strength of the rotationally symmetric lenses. However, the length of the astigmatic cross-over line is in the order of 10 mm; this means that, in practice, the strength of the quadrupole lenses can afford to be somewhat less.

Embodiment 5

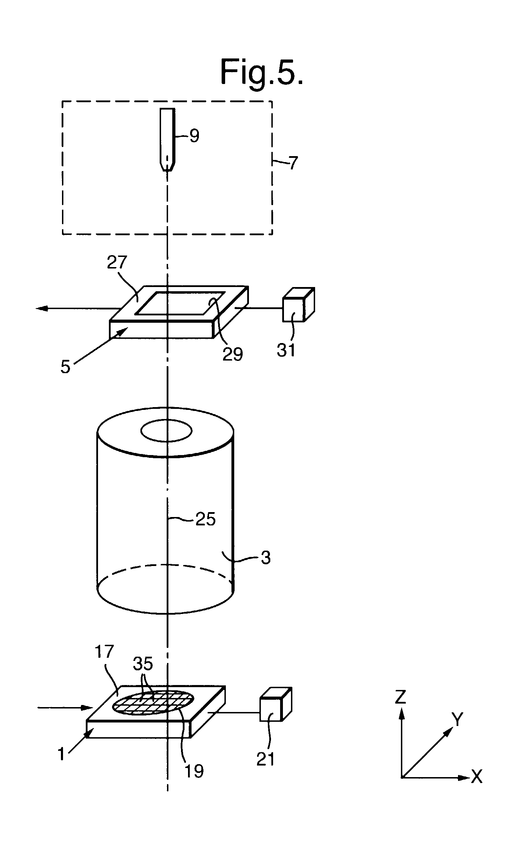

Figure 5 renders a schematic perspective view of a lithographic projection apparatus according to the invention. The apparatus comprises:

- a radiation system 7 for supplying a projection beam of charged particles, *e.g.* ions or electrons;
- a mask table 5 provided with a mask holder 27 for holding a mask 29 *(e.g.* a reticle);
- a substrate table 1 provided with a substrate holder 17 for holding a substrate 19 *(e.g.* a resist-coated silicon wafer);
- a projection system 3 for imaging an irradiated portion of the mask 29 onto a target portion 35 (die) of the substrate 19.

The radiation system 7 comprises a source 9 *(e.g.* a thermionic cathode or ion gun) which produces a beam 33 of radiation. This beam 33 is passed along various field components (not depicted) so that the beam emerging from the system 7 is substantially collimated and uniformly intense throughout its cross-section.

The projection beam subsequently intercepts a reticle 29 that is held in a mask holder 27 on a mask table 5. With the aid of the displacement means 31, the mask table 5 can be moved accurately back and forth along at least the X-direction (the so-called scan direction).

Having passed through the reticle 29, the projection beam passes through a projection system 3, which focuses the beam onto a die 35 of the wafer 19. In accordance with the invention, the projection system 3 comprises three or more quadrupole lenses, as well as various deflector plates, none of which are depicted in this schematic drawing.

With the aid of the displacement means 21, the substrate table 1 can also be moved accurately back and forth along the X-direction (scan direction). However, the substrate table 1 can also be moved back and forth in at least the Y-direction.

The depicted apparatus can, in principle, be used in two different modes:

- In step mode, the reticle table 5 is kept stationary, and an entire reticle image is projected in one go *(i.e.* a single "flash") onto a wafer die 35. The substrate table 1 is then shifted in the X and/or Y directions so that a different die 35 can be irradiated by the (stationary) beam 25;
- In scan mode, essentially the same scenario applies, except in that a given die 35 is not exposed in a single "flash". Instead, the reticle table is moved in the scan direction with a speed $v$, so that the projection beam 25 is caused to scan over a reticle image, and the substrate table 1 is simultaneously moved in the same or opposite direction at a speed $V = Mv$, in which $M$ is the magnification of the projection system 3 (typically, $M$ = 1/4 or 1/5). In this manner, a relatively large die can be exposed, without having to compromise on resolution.

Embodiment 6

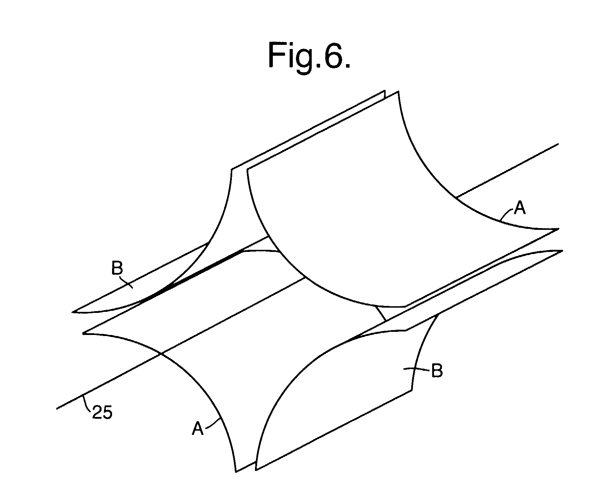

Figure 6 renders a perspective view of a quadrupole lens suitable for use in the current invention. A particle beam can be passed along the axis 25, which passes between two pairs of symmetrically arranged, curved poles A, A,B,B. The poles A,A are situated opposite one another, as are the poles B,B.

In the case of a magnetic quadrupole lens, the poles A,A,B,B are in fact the curved pole faces of (electro) magnets; the poles A,A are then, for example, north poles, whereas the poles B,B are south poles.

In the case of an electric quadrupole lens, the poles A,A,B,B are electrodes; the poles A,A are then, for example, at a positive potential, whereas the poles B,B are at a negative potential.

Significant geometrical dimensions of the quadrupole lens include the radius of the poles A,B, the mutual separation of the poles in each pair A,A and B,B, and the axial lengths of the poles A,B.

**Claims**

**1.** A lithographic apparatus comprising:

- a radiation system for supplying a projection beam of charged particles;
- a mask table for holding a mask;
- a substrate table for holding a substrate;

- a projection system for imaging an irradiated portion of the mask onto a target portion of the substrate,

characterized in that the projection system comprises at least three quadrupole lenses arranged successively along the path of the beam.

2. An apparatus according to Claim 1, characterized in that the projection system contains 3 quadrupole lenses.

3. An apparatus according to Claim 1, characterized in that the projection system contains 4 quadrupole lenses.

4. An apparatus according to Claim 1, characterized in that the projection system contains 5 quadrupole lenses.

5. An apparatus according to Claim 2, characterized in that:

- the magnification factor M of the projection system;
- the respective focal lengths $f_1$, $f_2$, $f_3$ of the quadrupole lenses;
- the mutual separations $b_{M1}$, $b_{12}$, $b_{23}$, $b_{3S}$ of the mask table and the first quadrupole lens, the first and second quadrupole lens, the second and third quadrupole lens, and the third quadrupole lens and substrate table, respectively,

are such that the following relationships are at least approximately satisfied:

$$f_3 = +Mf_1;$$

$$f_2 = -Mf_1;$$

$$b_{23} = Mb_{12};$$

$$b_{3S} = Mb_{M1}.$$

6. An apparatus according to Claim 3, characterized in that:

- the magnification factor M of the projection system;
- the respective focal lengths $f_1$, $f_2$, $f_3$, $f_4$ of the quadrupole lenses;
- the mutual separations $b_{M1}$, $b_{12}$, $b_{23}$, $b_{34}$, $b_{4S}$ of the mask table and the first quadrupole lens, the first and second quadrupole lens, the second and third quadrupole lens, the third and fourth quadrupole lens, and the fourth quadrupole lens and substrate table, respectively;
- the respective excitations $E_1$, $E_2$, $E_3$, $E_4$ of the quadrupole lenses,

are such that the following relationships are at least approximately satisfied:

$$f_3 = Mf_1;$$

$$f_4 = Mf_2;$$

$$b_{34} = Mb_{12};$$

$$b_{4S} = Mb_{M1};$$

$$b_{23} = b_{4S} + b_{M1};$$

$$E_1 = E_3;$$

$$E_2 = E_4.$$

**7.** An apparatus according to Claim 6, characterized in that at least one geometrical dimension of the third and fourth quadrupole lenses is scaled by a factor M with respect to the corresponding geometrical dimension of the first and second quadrupole lenses.

**8.** An apparatus according to any of the Claims 1-7, characterized in that the projection system additionally comprises at least one rotationally symmetric lens.

**9.** An apparatus according to any of the Claims 1-8, characterized in that the projection system additionally comprises at least one $n$-pole lens, where $n$ is an even integer greater than 4.

**10.** An apparatus according to any of the Claims 1-9, characterized in that, at each astigmatic crossover in the projection system, a slit-like aperture is located in the path of the beam.

**11.** An apparatus according to any of the Claims 1-10, characterized in that, at at least one astigmatic crossover in the projection system, at least one slit-like aperture is located off-axis of the projection beam.

**12.** A device manufacturing method comprising the steps of:

- providing a substrate which is at least partially covered by a layer of radiation-sensitive material;
- providing a mask which contains a pattern;
- using a projection beam of charged-particle radiation to project an image of at least

part of the mask pattern onto a target area of the layer of radiation-sensitive material, characterized in that, prior to impinging on the substrate, the projection beam is passed through at least three quadrupole lenses, arranged successively along its path.

**13.** A device manufactured in accordance with the method of Claim 12.

# Fig.1.

# Fig.2.

# Fig.3.

# Fig.4.

# Fig.5.

# Fig.6.